Europäisches Patentamt

European Patent Office

Office européen des brevets

(11) Publication number: **0 301 569 B1**

# EUROPEAN PATENT SPECIFICATION

(45) Date of publication of patent specification: **10.02.93** (51) Int. Cl.5: **G11C 16/02**

(21) Application number: **88112318.6**

(22) Date of filing: **29.07.88**

(54) **Semiconductor memory device and a method of controlling the same.**

(30) Priority: **31.07.87 JP 191557/87**

(43) Date of publication of application:
**01.02.89 Bulletin 89/05**

(45) Publication of the grant of the patent:
**10.02.93 Bulletin 93/06**

(84) Designated Contracting States:
**DE FR GB**

(56) References cited:
**GB-A- 2 094 086**
**US-A- 4 575 823**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Matsukawa, Naohiro c/o Patent Division**
**Kabushiki Kaisha Toshiba 1-1 Shibaura 1-chome**
**Minato-ku Tokyo 105(JP)**

(74) Representative: **Ritter und Edler von Fischern, Bernhard,Dipl.-Ing. et al**
**HOFFMANN - EITLE & PARTNER Arabellastrasse 4**
**W-8000 München 81(DE)**

## Description

The present invention relates to a semiconductor memory device such as a nonvolatile semiconductor memory capable of maintaining high reliability against so-called soft write and of performing high-speed read access.

Conventionally, in the case where a floating gate transistor is used as a memory cell for an EPROM (Ultra-violet erasable programmable ROM), data is read out from the memory cell by employing a drain voltage of 1.5 to 2 V and a control voltage of 5 V, the latter being the same as the memory power source voltage. In this case, the potential of a floating gate of the memory cell is at 3 to 4 V, and the difference in voltage between the drain and floating gate is about 2.5 V or less.

Using the method described above, the current flowing through the memory cell (cell current) is small and thus the read time, from the memory cell to a bit line (bit-line read time), is undesirably as long as, for example, 100 ns.

One method of increasing the cell current in the read mode, and thereby shorten the read time, is to increase the control gate voltage and hence the cell current. However, when the control gate voltage of the conventional floating gate memory cell is increased, it has been assumed that a gate current is increased upon an increase in cell current, and a write error (so-called soft write) in the read mode occurs (e.g., S. Ohya, M. Kikuchi and Y. Narita; Single 5 V EPROM with sub-micron memory transistor and on-chip high voltage generator; Technical Digest IEDM 83(1983), p. 570).

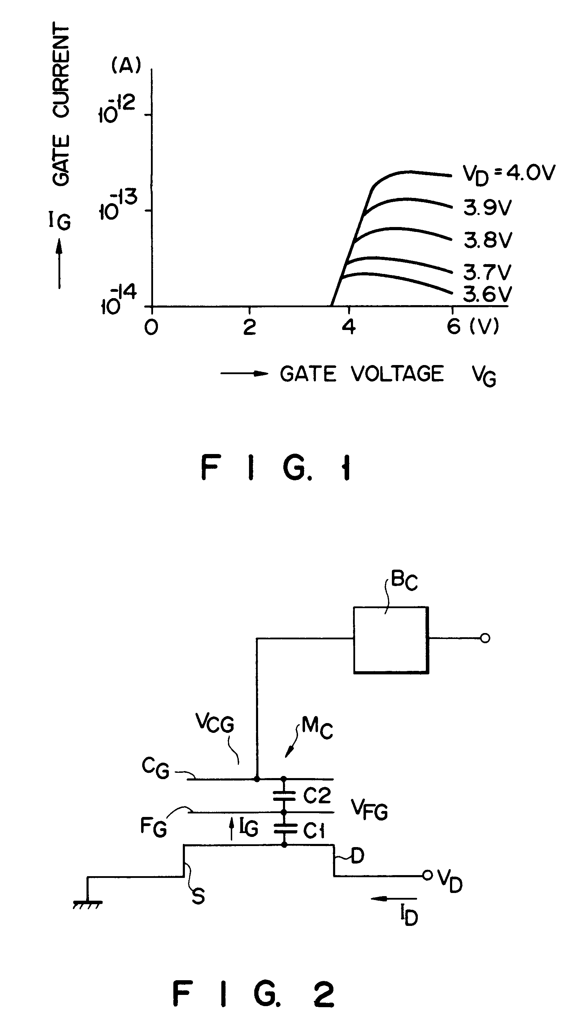

The soft write mechanisms described above, however, are, as yet, not completely understood. As is shown in Fig. 1, gate voltage VG vs. gate current IG characteristics of the conventional MOS (insulated-gate type) FET (field effect transistor) in a range where drain voltage VD is about 3.5 V or more have been clarified. However, the characteristics are unknown in a range where drain voltage VD is 3 V or less.

It is an object of the present invention to provide a semiconductor memory device in which soft write doesn't occur, which performs high-speed read access of a floating gate memory cell.

The semiconductor memory device according to the present invention as claimed in claim 1 includes a floating gate memory cell comprising a source and a drain for receiving a drain voltage of no more than 3 V during read-driving of said memory cell, a floating gate and a control gate for receiving a control gate voltage such that the floating gate voltage is higher during read-driving than the drain voltage by not less than about 3 V.

According to a method of driving the semiconductor memory device of the present invention, a voltage of 3 V or less is applied to the drain of the floating gate memory cell during read-driving thereof, and a voltage is applied to the control gate such that the floating gate voltage is higher than the drain voltage by about 3 V or more.

An unknown relationship between the gate current, the floating gate voltage, and the control gate voltage in a region where the drain voltage in the floating gate memory cell is 3 V or less, has been studied. In the region where the drain voltage is 3 V or less, when the floating gate voltage is substantially higher than the drain voltage, a cell current is increased upon an increase in control gate voltage. However, when control gate voltage is increased, a gate current is abruptly decreased upon an increase in floating gate voltage, and hence an amount of soft write is decreased. In particular, when the floating gate voltage is substantially equal to the drain voltage, the gate voltage is maximized. However, when the floating gate voltage is higher than the drain voltage by about 3 V or more, the gate current is decreased to about 1/10 or less of the maximum value. As described above, the control gate voltage of the conventional circuit, required for increasing the floating gate voltage, is normally set to be higher than a drive voltage of a memory peripheral circuit. By arranging a booster circuit in the memory, a required control gate voltage can be obtained.

According to the semiconductor memory device of the present invention, when the drain voltage of the floating gate memory cell is about 3 V or less, during read-driving of the memory cell, high reliability against soft write can be maintained and high-speed read access (about twice the conventional case) can be performed. Therefore, the semiconductor memory device can be effectively applied to an EPROM integrated circuit and a memory-mounted device (on-chip memory).

This invention can be more fully understood from the following detailed description when taken in conjunction with the accompanying drawings, in which:

Fig. 1 is a graph showing gate voltage VG vs. gate current IG characteristics of a conventional MOSFET;

Fig. 2 is a circuit diagram showing a semiconductor memory device and, more specifically, one of the memory cells which make up a memory cell array of an EPROM according to the present invention;

Fig. 3 is a graph showing floating gate voltage VFG vs. gate current IG characteristics of the semi-conductor memory device according to the present invention; and

Fig. 4 is a graph showing drain voltage VD vs. drain current ID of the semiconductor memory device according to the present invention.

A preferred embodiment of the present invention will now be described in detail, with reference to the accompanying drawings.

Fig. 2 shows memory cell MC, which is one of the memory cells making up a memory cell array of an EPROM. In memory cell MC, source S of a floating gate transistor is grounded, drain D is connected to a bit line, and control gate CG is connected to a word line via booster circuit BC. During read-driving of memory cell MC, drain voltage VD is set at 3 V or less, and control gate voltage VCG is set, by booster circuit BC, at a value such that floating gate voltage VFG is substantially higher than drain voltage VD.

Soft write characteristics of the above EPROM were measured using drain voltage VD as a parameter. Floating gate voltage VFG vs. gate current IG characteristics shown in Fig. 3 were obtained by conversion. If the capacitance between floating gate FG and a semiconductor substrate in memory cell MC is represented by C1, and that between floating gate FG and control gate CG is represented by C2, floating gate voltage VFG can be calculated as follows:

$$VFG = VCG \times C2/(C1 + C2) \qquad (1)$$

If the application time for drain voltage VD and control gate voltage VCG is represented by T and soft write amount is represented by $\Delta Vt$, gate current IG can be calculated as follows:

$$IG = (\Delta Vt \times C2)/T \qquad (2)$$

According to the above characteristics shown in Fig. 3, in a region where drain voltage VD is 3 V or less, when floating gate voltage VFG is substantially equal to drain voltage VD, gate current IG is maximized. In a region where floating gate voltage VFG is substantially higher than drain voltage VD, gate current IG is abruptly decreased upon an increase in floating gate voltage VFG and, when floating gate voltage VFG is higher than drain voltage VD by about 3 V or more, gate current IG is decreased to 1/10 or less of the maximum value. In other words, in the region where floating gate voltage VFG is substantially higher than drain voltage VD, gate current IG is abruptly decreased upon an increase in floating gate voltage VFG. Therefore, soft write is not easily caused.

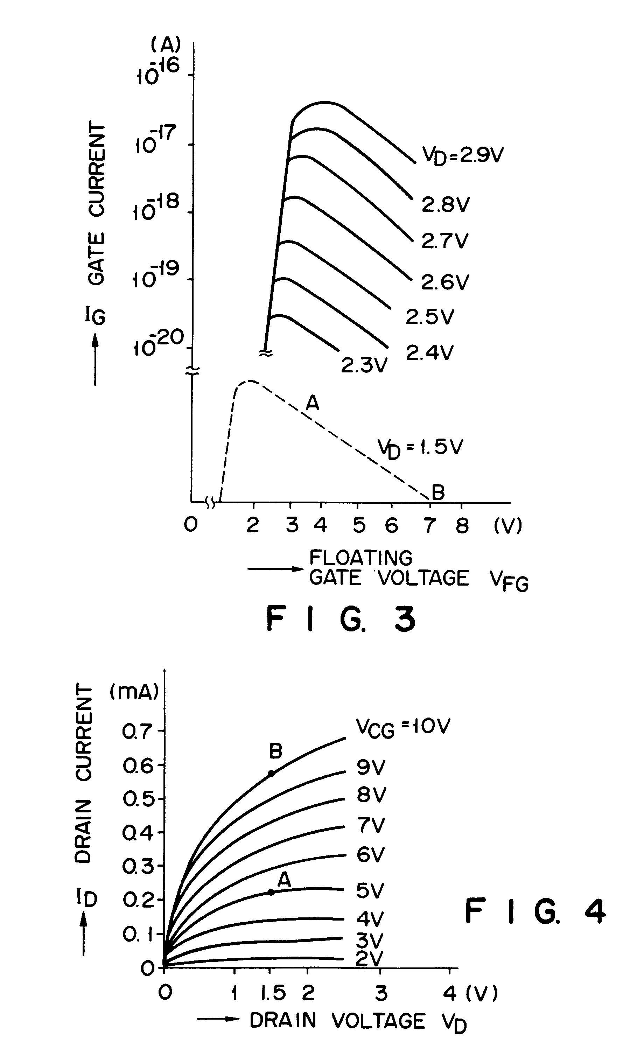

On the other hand, drain voltage VD vs. drain current (cell current) ID characteristics of memory cell MC described above were measured using control gate voltage VCG as a parameter. As is shown in Fig. 4, the cell current is confirmed by what to be increased as control gate voltage VCG is increased. Therefore, as described above, when control gate voltage VCG is set at a properly large value (in general, a voltage higher than the drive voltage of a memory peripheral circuit arranged in the memory) in the region where floating gate voltage VFG is substantially higher than drain voltage VD, high-speed read access can be achieved.

An operation of this embodiment of the present invention will now be described in detail.

When drain voltage VD = 1.5 V and control gate voltage VCG = 10 V are applied to a memory cell having capacitance C1 = 1 fF and capacitance C2 = 2.5 fF, and read access is performed, the following floating gate voltage is obtained:

$$VFG = 10 \text{ V} \times 2.5/(1 + 2.5) = 7 \text{ V}$$

This voltage is about twice the conventional case wherein VFG = 3.5 V at VCG = 5 V. Therefore, according to the characteristics shown in Fig. 3, since gate current IG at point B in this embodiment is decreased to 1/10 or less of gate current IG at point A in the conventional case, according to this embodiment, it is expected that reliability against soft write is improved. In the above case, according to the characteristics shown in Fig. 4, a cell current at point B (about 0.58 mA) in this embodiment is about twice a cell current at point A (about 0.22 mA) in the conventional case, and a bit line read time in this embodiment is reduced to 1/2, (i.e., about 50 ns) the conventional read time (i.e., 100 ns).

Control gate voltage VCG of the above-described memory cell in the read mode is set higher than a drive voltage of a memory peripheral circuit or an externally supplied power supply voltage. By arranging booster circuit BC in memory cell MC, a required control voltage can be obtained. Control gate voltage VCG of the memory cell in the read mode may be derived from the externally supplied power supply voltage, and the drain voltage may be supplied from a power source voltage-lowering circuit. That is, voltages of predetermined levels can be applied to both the control gate and the drain by properly using a booster circuit and a voltage-lowering circuit.

The present invention is not limited to the EPROM. The present invention can generally be applied to semi-conductor memory device having floating gate memory cells.

## Claims

1. A semiconductor memory device including a floating gate memory cell, comprising:
   a source (S) and a drain (D) for receiving a drain voltage of not more than 3 V during read-driving of said memory cell (MC);
   a floating gate (FG); and
   a control gate (CG) for receiving a control gate voltage such that a floating gate voltage is higher during read-driving than the drain voltage by not less than about 3 V.

2. A device according to claim 1, characterized in that the control gate voltage to be applied to said control gate (CG) in said memory cell (MC) during read-driving of said memory cell (MC) is higher than a drive voltage of a peripheral circuit of said memory cell (MC).

3. A device according to claim 1, characterized in that the control gate voltage to be applied to said control gate (CG) in said memory cell (MC) during read-driving of said memory cell (MC) is higher than an externally supplied power supply voltage.

4. A device according to claim 1, characterized in that said memory cell is an ultra-violet erasable programmable ROM.

5. A method of driving a semiconductor memory device including a floating gate memory cell, comprising the steps of, during read-driving of a memory cell (MC), applying a drain voltage of not more than 3 V to a drain (D) of said memory cell, and a control gate voltage to a control gate (CG) of said memory cell (MC), the control gate voltage being of such a value that a floating gate voltage of a floating gate (FG) is higher than the drain voltage by not less than about 3 V.

6. A method according to claim 5, characterized in that the control gate voltage which is applied to said control gate (CG) of said memory cell (MC) during read-driving of said memory cell (MC) is generated by a booster circuit (BC).

7. A method according to claim 5, characterized in that, during read-driving of said memory cell (MC), the control gate voltage applied to said control gate (CG) in said memory cell (MC) is higher than a drive voltage of a peripheral circuit of said memory cell (MC).

**Patentansprüche**

1. Halbleiterspeichervorrichtung, welche eine Speicherzelle mit erdfreiem Gate beinhaltet, mit:
einer Source (S) und einem Drain (D) zum Empfangen einer Drain-Spannung von nicht mehr als 3 V während einer Leseansteuerung der Speicherzelle (MC);
einem erdfreien Gate (FG); und
einem Steuergate (CG) zum Empfangen einer Steuergatespannung so, daß eine Spannung des erdfreien Gates höher während der Leseansteuerung als die Drain-Spannung um nicht weniger als 3 V ist.

2. Vorrichtung nach Anspruch 1,
dadurch **gekennzeichnet,** daß
die Steuergatespannung zum Anlegen an das Steuergate (CG) in der Speicherzelle (MC) während der Leseansteuerung der Speicherzelle (MC) höher als eine Ansteuerungs-Spannung eines peripherischen Schaltkreises der Speicherzelle (MC) ist.

3. Vorrichtung nach Anspruch 1,
dadurch **gekennzeichnet,** daß
die Gate-Steuerspannung zum Anlegen an das Steuergate (CG) in der Speicherzelle (MC) während der Leseansteuerung der Speicherzelle (MC) höher als eine extern angelegte Leistungszuführungsspannung ist.

4. Vorrichtung nach Anspruch 1,
dadurch **gekennzeichnet,** daß
die Speicherzelle ein Ultraviolett-löschbares programmierbares ROM ist.

5. Verfahren zum Ansteuern einer Halbleiterspeichervorrichtung, welche eine Speicherzelle mit erdfreiem Gate beinhaltet, mit den Schritten:
Während der Leseansteuerung einer Speicherzelle (MC) Anlegen einer Drainspannung von nicht mehr als 3 V an einen Drain (D) der Speicherzelle, und einer Steuerspannung an ein Steuergate (CG) der Speicherzelle (MC), wobei die Steuerspannung solch einen Wert hat, daß eine Spannung des erdfreien Gates (FG) höher als die Drain-Spannung um nicht weniger als 3 V ist.

6. Verfahren nach Anspruch 5,
dadurch **gekennzeichnet,** daß
die Gate-Steuerspannung, welche an das Steuergate (CG) der Speicherzelle (MC) während der Leseansteuerung der Speicherzelle (CG) angelegt wird, durch einen Verstärkungsschaltkreis (BC) erzeugt wird.

7. Verfahren nach Anspruch 5,
dadurch **gekennzeichnet,** daß
während der Leseansteuerung der Speicherzelle (MC) die Gate-Steuerspannung, die an das Steuergate (CG) in der Speicherzelle (MC) angelegt wird, höher als eine Ansteuerspannung eines peripherischen Schaltkreises der Speicherzelle (MC) ist.

**Revendications**

1. Dispositif de mémoire à semiconducteur incluant une cellule de mémoire à grille flottante, comprenant:

   une source (S) et un drain (D) pour recevoir une tension de drain au plus égale à 3 volts pendant une commande de lecture de ladite cellule de mémoire (MC);

   une grille flottante (FG); et

   une grille de commande (CG) pour recevoir une tension de grille de commande telle que la tension de grille flottante est supérieure à la tension de drain d'au moins 3 volts environ pendant une commande de lecture.

2. Dispositif selon la revendication 1, caractérisé en ce que la tension de grille de commande à appliquer à ladite grille de commande (CG) dans ladite cellule de mémoire (MC) pendant une commande de lecture de ladite cellule de mémoire (MC) est supérieure à la tension de commande d'un circuit périphérique de ladite cellule de mémoire (MC).

3. Dispositif selon la revendication 1, caractérisé en ce que la tension de grille de commande à appliquer à ladite grille de commande (CG) dans ladite cellule de mémoire (MC) pendant une commande de lecture de ladite cellule de mémoire (MC) est supérieure à la tension de source d'alimentation fournie de l'extérieur.

4. Dispositif selon la revendication 1, caractérisé en ce que ladite cellule de mémoire est une mémoire morte ROM programmable effaçable par ultraviolets.

5. Méthode de commande d'un dispositif de mémoire à semiconducteur incluant une cellule de mémoire à grille flottante, comprenant les étapes qui consistent, pendant une commande de lecture d'une cellule de mémoire(MC),à appliquer une tension de drain au plus égale à 3 volts à un drain (D) de ladite cellule de mémoire, et une tension de grille de commande à une grille de commande (CG) de ladite cellule de mémoire(MC), la tension de grille de commande ayant une valeur telle que la tension de grille flottante d'une grille flottante (FG) est supérieure à la tension de drain d'au moins 3 volts environ.

6. Méthode selon la revendication 5, caractérisée en ce que la tension de grille de commande qui est appliquée à ladite grille de commande (CG) de ladite cellule de mémoire (MC) pendant une commande de lecture de ladite cellule de mémoire (MC) est générée par un circuit survolteur (BC).

7. Méthode selon la revendication 5, caractérisée en ce que, pendant une commande de lecture de ladite cellule de mémoire (MC), la tension de grille de commande appliquée à ladite grille de commande (CG) dans ladite cellule de mémoire (MC) est supérieure à la tension de commande d'un circuit périphérique de ladite cellule de mémoire (MC).

F I G. 1

F I G. 2

**F I G. 3**

**F I G. 4**